Europäisches Patentamt

European Patent Office

Office européen des brevets

(19)

(11) Veröffentlichungsnummer: **0 290 438 B1**

(12) **EUROPÄISCHE PATENTSCHRIFT**

(45) Veröffentlichungstag der Patentschrift:
**22.05.91 Patentblatt 91/21**

(51) Int. Cl.⁵: **B60C 23/04**, H03K 6/02,
H05F 3/00, G08C 15/12,
H04J 3/06

(21) Anmeldenummer: **87900065.1**

(22) Anmeldetag: **24.12.86**

(86) Internationale Anmeldenummer:
**PCT/DE86/00523**

(87) Internationale Veröffentlichungsnummer:
**WO 87/04123 16.07.87 Gazette 87/15**

(54) SCHALTUNGSANORDNUNG ZUR MESSWERTÜBERTRAGUNG AN FAHRZEUGRÄDERN.

(30) Priorität: **08.01.86 DE 3600260**

(43) Veröffentlichungstag der Anmeldung:
**17.11.88 Patentblatt 88/46**

(45) Bekanntmachung des Hinweises auf die
Patenterteilung:
**22.05.91 Patentblatt 91/21**

(84) Benannte Vertragsstaaten:
**DE FR GB IT SE**

(56) Entgegenhaltungen:
**WO-A-82/02249**
**FR-A- 2 225 300**
**FR-A- 2 454 383**
**FR-A- 2 577 060**
**GB-A- 2 122 757**

(73) Patentinhaber: **ROBERT BOSCH GmbH**
**Postfach 10 60 50**
**W-7000 Stuttgart 10 (DE)**

(72) Erfinder: **BOLLWEBER, Lothar**
**Silberaustr. 25**
**W-7551 Steinmauern (DE)**
Erfinder: **JANSCHE, Walter**
**Pestalozzistr. 7**
**W-7552 Durmersheim (DE)**
Erfinder: **HUGEL, Robert**
**Joseph-von-Eichendorff-Str. 9**
**W-7500 Karlsruhe (DE)**
Erfinder: **PILCH, Claus-Dietrich**
**Gleiwitzer Str. 7**
**W-7537 Remchingen 3 (DE)**
Erfinder: **ROTHLEY, Manfred**
**Südendstr. 41**
**W-7257 Kraichtal 2 (DE)**
Erfinder: **ZABLER, Erich**
**Brunhildstr. 11**
**W-7513 Stutensee 1 (DE)**

**Beschreibung**

Die Erfindung geht aus von einer Schaltungsanordnung zur Übertragung von veränderlichen Meßwerten wie Druck und Temperatur an Fahrzeugrädern nach der Gattung des Hauptanspruchs. Aus der DE-PS 30 29 563 ist bereits eine derartige Schaltungsanordnung bekannt, bei der mit einem niederfrequenten Zerhacker über eine ortsfeste Übertragerspule Energie auf eine umlaufende Übertragerspule mit daran angeschlossener Sensorschaltung übertragen wird. Die Meßwerte der Sensoren am Fahrzeugrad werden über einen Wandler in frequenzanaloge Signale umgesetzt, die ein Vielfaches der Zerhackerfrequenz betragen und die von den Übertragerspulen über einen Hochpaß in die ortsfeste Auswerteschaltung gelangen. Solange ein Schwellwertschalter in der Sensorbeschaltung den Meßwertwandler aktiviert, unterbricht die ortsfeste Auswerteschaltung den Zerhacker. Dadurch wird während der Rückübertragung des Informationssignals über die Wandlerspulen keine Energie in die Sensorbeschaltung übertragen und damit werden die über denselben Kanal gelangenden Informationssignale von der Energieübertragung getrennt.

Bei dieser bekannten Lösung ist es nachteilig, daß die gemessenen Werte des Reifendrucks und der Reifentemperatur nicht getrennt voneinander in die Auswerteschaltung übertragen werden sondern daß sie bereits in der Sensorschaltung derart miteinander verknüpft werden, daß sich daraus ein sogenannter temperaturkompensierter Reifendruck als Meßwert ergibt. Des weiteren ist nachteilig, daß der Frequenzbereich für die Signalübertragung relativ groß wird, wenn eine feine Stufung der zu übertragenden Meßwerte erwünscht ist. Außerdem ist die Zeit der Meßwertübertragung bei der bekannten Lösung abhängig von der Ladung eines Speicherkondensators, der zuvor durch den eingeschalteten Zerhacker geladen wurde. Die Meßwertübertragung wird dadurch in unerwünschter Weise verzögert.

Mit der vorliegenden Lösung wird angestrebt, die Meßwerte schnell in Form einer Impulsfolge in fest vorgegebenen Zeitabschnitten in den Einschaltpausen eines ortsfesten Rechteckgenerators zur Energieversorgung der Sensorbeschaltung auf die Auswerteschaltung zu übertragen, um so eine hohe Informationsauflösung und folglich eine feine Stufung der zu übertragenden Meßwerte zu erzielen.

Vorteile der Erfindung

Die erfindungsgemäße Schaltungsanordnung mit den kennzeichnenden Merkmalen des Hauptanspruches hat den Vorteil, daß mit dem niederfrequenten Takt des ortsfesten Rechteckgenerators zur Energieversorgung der Sensorbeschaltung Meßwerte an Fahrzeugrädern mit hoher Auflösung als digitale Impulsfolge zur Auswerteschaltung gelangen können, wobei die Übertragungszeit für jeden Meßwert festliegt. Als weiterer Vorteil ist anzusehen, daß die in den Übertragerspulen beim Abschalten der Versorgungsspannung im Takt des Rechteckgenerators induzierte Spannungsspitze nicht in die Zeitspanne für die Signalübertragung fällt und damit keine Verfälschung der zu übertragenden Meßwerte bewirken kann. Außerdem werden diese Spannungsspitzen in vorteilhafter Weise dafür verwendet, mit einer vorbestimmten Zeitverzögerung die Meßwertübertragung auszulösen und über eine vorgegebene Zeit zu sichern. Durch die auf diese Weise in schneller Folge von den Fahrzeugrädern übermittelten Meßwerte bzw. Meßwertänderungen ist es möglich, diese auch noch zur Reifendruckregelung heranzuziehen.

Durch die in den Unteransprüchen aufgeführten Maßnahmen sind vorteilhafte Weiterbildungen und Verbesserungen der im Hauptanspruch angegebenen Merkmale möglich. Besonders vorteilhaft ist es, wenn die von dem auf die Spannungsimpulse, ansprechenden Zeitglied der Sensorbeschaltung freigegebene Zeitschaltung zur Meßwertübertragung eine monostabile Kippstufe ist, über deren Ausgang eine dem Meßwertwandler nachgeschaltete Koppelstufe für die Weiterleitung der HF-Signale auf die umlaufende Übertragerspule einzuschalten ist. Die Koppelschaltung ist dabei in vorteilhafter Weise aus zwei in Reihe liegende, an die Versorgungsspannung der Sensorschaltung angeschlossene Transistorschalter gebildet, die vom Ausgang des Meßwertwandlers im Gegentakt gesteuert werden und deren Verbindung über eine Kapazität mit der umlaufenden Übertragerspule gekoppelt ist. Eine besonders hohe Auflösung der Meßwerte wird dadurch gewährleistet, daß der Meßwertwandler ein Analog-Digital-Codierer ist, der die Meßwerte mindestens eines Sensors als serielle Bitfolge im Dualcode auf die Koppelschaltung gibt und dem ein entsprechender Decodierer in der Auswerteschaltung zugeordnet ist.

Zeichnung

Ein Ausführungsbeispiel der Erfindung ist in der Zeichnung dargestellt und in der nachfolgenden Beschreibung näher erläutert. Es zeigen Figur 1 ein Blockschaltbild der erfindungsgemäßen Schaltungsanordnung zur Meßwertübertragung an Fahrzeugrädern, Figur 2 den Schaltungsaufbau einer Koppelstufe in der Sensorbeschaltung, Figur 3 zeigt ein Schaltschema der ortsfesten Auswerteschaltung, Figur 4 zeigt ein Schaltschema des Rechteckgenerators und Figur 5 zeigt den Spannungs- bzw. Signalverlauf an verschiedenen Punkten der erfindungsgemäßen Schaltungsanordnung.

Beschreibung des Ausführungsbeispieles

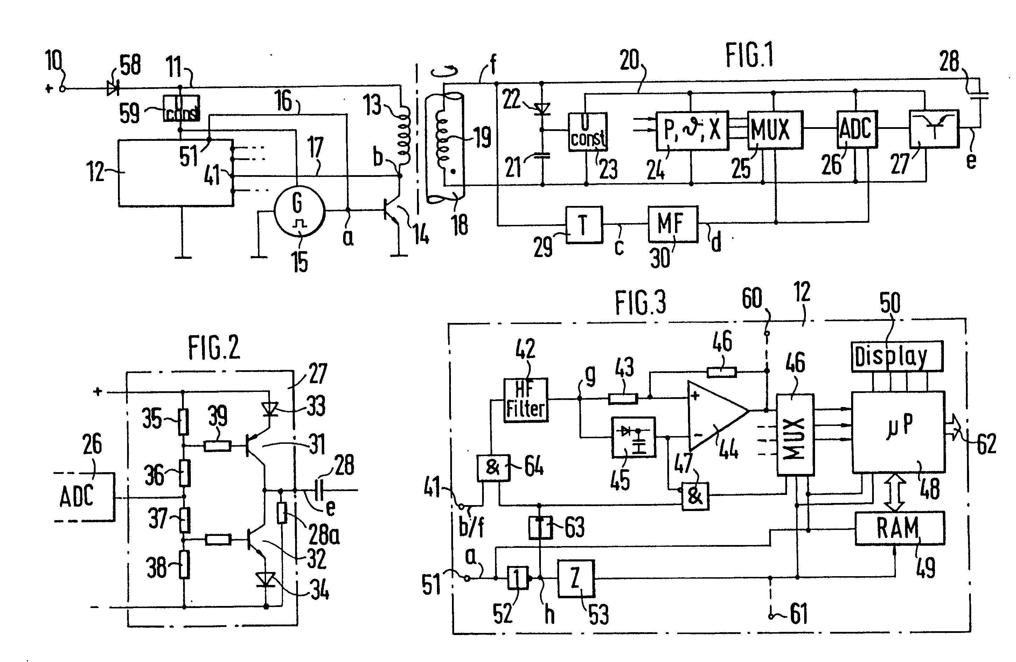

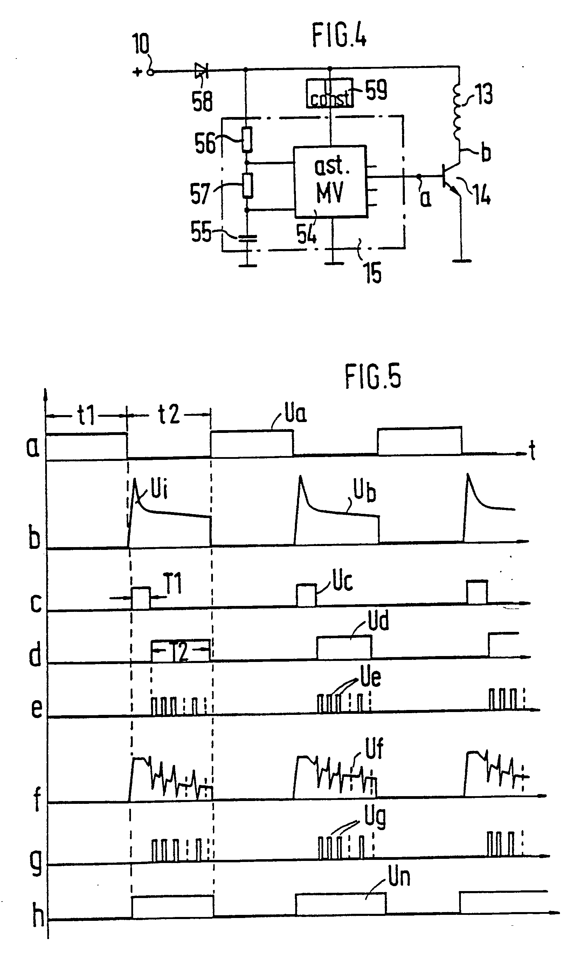

In Figur 1 ist die erfindungsgemäße Schaltungsanordnung zur Überwachung von veränderlichen Meßwerten wie Druck und Temperatur an einem Rad eines Kraftfahrzeuges als Blockschaltbild dargestellt. Sie besteht aus einem am Fahrzeug ortsfesten Schaltungsteil, der mit einer Plusklemme 10 an die Batteriespannung des Fahrzeugs anzuschließen ist. Die Spannung liegt über eine Verpolschutzdiode 58, eine Versorgungsleitung 11 und einen Spannungsregler 59 an einer Auswerteschaltung 12, die mit Figur 3 näher erläutert wird, und ferner an einem Ende einer in Radnähe ortsfest angeordneten Übertragerspule 13. Das andere Ende der Übertragerspule 13 ist über einen npn-leitenden Schalttransistor 14 gegen Masse geschaltet. Ebensogut kann aber der Schalttransistor 14 auch pnp-leitend vor der Übertragerspule 13 liegen. Die Steuerelektrode des Schalttransistors 14 liegt am Ausgang eines Rechteckgenerators 15, der in Figur 4 näher dargestellt ist. Die Auswerteschaltung 12 ist über eine Leitung 16 mit dem Ausgang des Recheckgenerators 15 verbunden sowie mit einer Leitung 17 an die Verbindung zwischen Übertragerspule 13 und Schalttransistor 14 angeschlossen.

Das Fahrzeugrad ist durch eine Welle 18 symbolisch dargestellt, auf der eine mit dem Rad umlaufende Übertragerspule 19 angeordnet ist. Die ortsfeste Übertragerspule 13 sowie die umlaufende Übertragerspule 19 können im Lagerbereich des Fahrzeugrades konzentrisch übereinander oder axial nebeneinander angeordnet sein, so daß eine Meßwertübertragung auch bei stehendem Rad möglich ist. Eine von der Raddrehung unabhängige Meßwertübertragung ist aber auch dann möglich, wenn die umlaufende Übertragerspule 19 als Ringspule am Umfang der Radfelge befestigt ist und die ortsfeste Übertragerspule 13 in deren Umfangsbereich am Fahrzeugaufbau, vorzugsweise am Bremssattel sitzt. Die umlaufende Übertragerspule 19 ist mit ihren Enden an eine Sensorbeschaltung 20 angeschlossen, die entweder gemeinsam mit den Sensoren im Tiefbett der Radfelge befestigt wird oder die getrennt von den Sensoren außen an der Radfelge angeordnet ist. Die Sensorbeschaltung 20 hat zur Energieversorgung einen Speicherkondensator 21, der über eine vorgeschaltete Diode 22 parallel zur Übertragungsspule 19 liegt und der von den positiven Halbwellen in der Übertragungsspule 19 mit dem Takt des Rechteckgenerators 15 auf etwa 22 V geladen wird. Zur Glättung der Versorgungsspannung ist der Speicherkondensator 21 an einen Spannungsregler 23 angeschlossen, der mit seinem stabilisierten Ausgang von 15 V mehrere Halbleiter-Sensoren 24 und weitere Schaltungsbausteine versorgt. Im Beispielsfall ist als Halbleitersensor ein Reifendruck-Sensor P und ein Temperatur-Sensor $\vartheta$ vorgesehen. Es können hier gegebenenfalls noch Sensoren $\underline{X}$ für weitere Meßgrößen bzw. für eine Zweifach-Messung von Druck und Temperatur vorgesehen sein. Die Meßsignale der Halbleiter-Sensoren 24 werden parallel auf einen Multiplexer 25 geführt, dessen Ausgang mit einem Analog-Digital-Codierer 26 als Meßwertwandler verbunden ist. Der Ausgang des Meßwertwandlers 26 ist mit einer Koppel- bzw. Treiberstufe 27 verbunden, die in Figur 2 im einzelnen dargestellt ist. Der Signalausgang der Treiberstufe 27 ist über einen Kondensator 28 mit der Übertragerspule 19 verbunden. Die Übertragerspule 19 ist außerdem an ein Zeitglied 29 angeschlossen, welches ausgangsseitig mit einer Zeitschaltung 30 verbunden ist. Die Zeitschaltung 30 ist im Beispielsfall als monostabile Kippstufe ausgebildet, deren Ausgang den Meßwertwandler 26 freigibt und der ferner auf den Steuereingang des Multiplexers 25 gelegt ist.

In Figur 2 ist der Aufbau der Treiberstufe 27 dargestellt, die im wesentlichen aus zwei in Reihe liegende, an die Ausgangsspannung des Spannungsreglers 23 angeschlossene Schalttransistoren 31 und 32 besteht. Ein pnp-Schalttransistor 31 ist mit vorgeschalteter Diode 33 mit dem Pluspotential der Versorgungsspannung verbunden, während dazu in Reihe ein npn-Schalttransistor 32 über eine nachgeschaltete Diode 34 am Minuspotential liegt. Ein ebenfalls mit der Versorgungsspannung verbundener Widerstandszweig aus vier in Reihe liegenden Widerständen 35, 36, 37 und 38 dient als Spannungsteiler, wobei zwischen den zwei ersten Widerständen 35 und 36 die Basis des pnp-Schalttransistors 31 über einen Basiswiderstand 39 angeschlossen ist. Die Basis des npn-Schalttransistors 32 ist über einen Basiswiderstand 40 an die Verbindung der zwei anderen Widerstände 37 und 38 angeschlossen. Die Mittelanzapfung zwischen den Widerständen 36 und 37 liegt am Ausgang des Meßwertwandlers 26, durch dessen Ausgangssignale die Schalttransistoren 31 und 32 im Gegentakt auf- und zugesteuert werden. Die Verbindung zwischen den beiden Schalttransistoren 31 und 32 ist zur Signalankopplung der Übertragerspule 19 an den Kondensator 28 angeschlossen und über einen Entladewiderstand 28a auf Minuspotential gelegt.

Figur 3 zeigt in schematischer Darstellung die Auswerteschaltung 12 aus Figur 1. Für jedes Fahrzeugrad ist hier ein mit der ortsfesten Übertragerspule 13 verbundener Signaleingang 41 über ein UND-Gatter 64, ein HF-Filter 42 und einen Widerstand 43 mit dem Pluseingang eines Schmitt-Triggers 44 verbunden, dessen Minus-Eingang über eine Gleichrichter- Glättungsstufe 45 am Ausgang des HF-Filters 42 liegt. Der Ausgang des Schmitt-Triggers 44 ist einerseits über einen Widerstand 46 auf den Plus-Eingang rückgekoppelt und andererseits auf einen Eingang eines weiteren Multiplexers 46 gelegt. Zur Synchronisation mit dem Multiplexer 25 der Sensorbeschaltung 20 ist ein Rücksetzeingang des Multiplexers 46 an den Ausgang eines UND-Gatters 47 gelegt, das mit seinem einem Eingang über eine Verzögerungsstufe 63 und einen Inverter 52 an einem Takteingang 53 und mit seinem weiteren, negierten Eingang am Minus-Eingang des Schmitt-Triggers 44 liegt. Zur Dekodierung und weiteren Verarbeitung der übertragenen Meßwert-Signale ist dem Multiplexer 46 ein Mikroprozessor 48 nachgeschaltet, welcher mit einem Meßwertspeicher 49 verbunden ist. Außerdem ist am Mikroprozessor 48 ein Display 50 angeschlossen, auf dem beim Auftreten kritischer Werte eine Anzeige erscheint. Im Bedarfsfall können die gemessenen Werte auch über an den Mikroprozessor 48 anzuschliessende Drucktasten aufgerufen und zur Anzeige gebracht werden. Über den Takteingang 51 der Auswerteschaltung werden außerdem die Ausgangssignale des Rechteckgenerators 15 auf einen Takteingang des Multiplexers 46, des Mikroprozessors 48 und des Meßwertspeichers 49 gegeben. Außerdem wird damit über den Inverter 52 ein Zähler 53 angesteuert, dessen Ausgang den Multiplexer 46, den Mikroprozessor 48 und den Datenein- und -ausgang des Meßwertspeichers 49 steuert. Die an Ausgang des Inverters 52 liegende Verzögerungsstufe 63 liegt ferner noch am zweiten Eingang des dem HF-Filter 42 vorgeschalteten UND-Gatters 64.

Figur 4 zeigt den schematischen Aufbau des Rechteckgenerators 15 aus Figur 1 zur Steuerung des Schalttransistors 14 im Stromkreis der Übertragerspule 13. Der Rechteckgenerator 14 enthält zur gleichmäßigen, von Schwankungen der Versorgungsspannung unabhängigen Energieversorgung der Sensorbeschaltung 20 eine astabile Kippschaltung 54, deren Zeitglied von einem Kondensator 55 und den nachgeschalteten Widerständen 56 und 57 gebildet wird, und das über die Diode 58 als Verpolschutz an der ungeregelten Versorgungsspannung an Klemme 10 liegt. Über die Diode 58 ist ferner die ortsfeste Übertragerspule 13 sowie der Eingang des Spannungsreglers 59, an Klemme 10 angeschlossen, dessen Ausgang die Schaltungen 12 (Figur 3) und 15 mit konstanter Spannung versorgt.

Im folgenden wird die Wirkungsweise der erfindungsgemäßen Schaltungsanordnung mit Hilfe der in Figur 5 dargestellten Spannungs- und Signalverläufe an verschiedenen Punkten der Schaltungsanordnung näher erläutert. Im Punkt a am Ausgang des Rechteckgenerators 15 werden mit der astabilen Kippstufe 54 Rechtecksignale Ua mit einer Frequenz von etwa 150 Hz auf den Steuereingang des Schalttransistors 14 und auf Klemme 51 der Auswerteschaltung 12 gegeben, dabei soll die Impulszeit t1 = 4 ms und die Pausenzeit t2 ≈ 3 ms betragen. Während der Impulszeit t1 wird der Schalttransistor 14 leitend gesteuert und es fließt durch die Übertragerspule 13 ein Strom, der ein mit der umlaufenden Übertragerspule 19 gekoppeltes Magnetfeld aufbaut. Mit Beginn der Pausenzeit t2 wird der Transistor 14 gesperrt, der Strom in der ortsfesten Übertragerspule 13 wird unterbrochen und demzufolge in beiden Übertragerspulen 13 und 14 eine Induktionsspannung Ub erzeugt, die im Punkt b der Schaltung zwischen Schalttransistor 14 und Übertragerspule 13 den in Figur 5 dargestellten Verlauf hat. Dabei tritt jeweils zunächst eine Spannungsspitze Ui auf, der ein abfallender Spannungsrücken folgt. Die Ansprechspannung des Zeitgliedes 29 in der Sensorbeschaltung 20 ist so eingestellt, daß sie durch diese Spannungsspitze Ui am Ausgang des Zeitgliedes 29 im Punkt c der Schaltung einen Spannungsimpuls Uc mit der Dauer T1 von 0,5 ms abgibt, durch den die nachgeschaltete Zeitschaltung 30 gesperrt wird. Nach Ablauf der Verzögerungszeit T1 wird nun die Zeitschaltung 30 freigegeben und im Punkt d am Ausgang der Zeitschaltung 30 erscheint gemäß Figur 5 ein Steuerimpuls Ud, welcher sowohl auf den Multiplexer 25 als auch auf den Steuereingang des Meßwertwandlers 26 gelangt und damit die Sensorbeschaltung 20 zur Meßwertübertragung freigibt. Die Einschaltdauer T2 der Zeitschaltung 30 und damit die Dauer des Steuerimpulses Ud zur Meßwertübertragung beträgt 2 ms. Eine vollständige und durch die Spannungsspitze Ui unbeeinflußte Meßwertübertragung wird dadurch gewährleistet, daß die Verzögerungszeit T1 des Zeitgliedes 29 zusammen mit der Einschaltdauer T2 der Zeitschaltung 30 kleiner ist als die Pausenzeit t2 der Signale Ua des Rechteckgenerators 14.

Der Multiplexer 25 schaltet zyklisch die von den Halbleitersensoren 24 erfaßten Meßwerte an einem Fahrzeugreifen in Form von analogen Spannungswerten auf den Meßwertwandler 26. Der Multiplexer 25 liegt dabei mit seinem Takteingang am Ausgang der Zeitschaltung 30 und schaltet jeweils mit der abfallenden Flanke der Impulse Ud, d.h. nach Ablauf der Einschaltdauer T2 den nächsten Sensor bzw. einen freigelassenen Eingang zyklisch auf seinen Ausgang um. Bis zum Ende der Einschaltdauer T2 gelangt folglich der Meßwert des vom Multiplexer 25 durchgeschalteten Halbleiter-Sensors 24 auf den Meßwertwandler 26. Durch den Steuerimpuls Ud der Zeitschaltung 30 wird nun der Meßwertwandler 26 für die Einschaltdauer T2 freigegeben und der Meßwert wird in bekannter Weise z.B. als serielle 8-Bit-Folge im Dualcode auf den Eingang der Koppelstufe 27 gegeben, durch die die Schalttransistoren 31 und 32 wechselweise ein- und ausgeschaltet werden. Im Punkt e am Ausgang der Koppelstufe 27 tritt dabei eine entsprechende serielle Bitfolge von Spannungsimpulsen Ue auf, die in Figur 5 dargestellt sind, wobei Leerstellen (logische Nullen) gestrichelt markiert sind, und die über den Kondensator 28 im Beispielsfall mit einer Frequenz von 20 KHz als Nadelimpulse auf die Übertragerspule 19 gelangen. Durch den Siebkondensator 28 wird zwar bei jedem Spannungsimpuls Ue ein positiver und ein negativer Nadelimpuls erzeugt. Da jedoch die positiven Nadelimpulse ebenso wie die Spannungsspitze Ui in der Übertragerspule 19 vom Speicherkondensator 21 begrenzt werden, sind nur die negativen Nadelimpulse für die Auswertung von Bedeutung. Die Nadelinpulse überlagern sich an der Übertragerspule 19 mit der induzierten Spannung Ub zur Energieübertragung zu dem im Punkt f der Schaltung am Eingang der umlaufenden Übertragerspule 19 in Figur 5 dargestellten Spannungsverlauf Ue. Ein entsprechender Spannungsverlauf ergibt sich auch an der ortsfesten Übertragerspule 13 im Punkt b der Schaltung, welcher über die Leitung 17 auf den Signaleingang 41 der Auswerteschaltung 12 (Figur 3) gelangt.

Über das HF-Filter 42 werden die Nadelimpulse Ug als serielle 8 Bit-Folge im Punkt g der Schaltung wieder ausgesiebt und über den Widerstand 43 auf den Plus-Eingang des Schmitt-Triggers 44 gegeben, wobei durch das vorgeschaltete UND-Gatter 64 mit dem von der Verzögerungsstufe 63 um etwa 0,4 ms zeitverzögerten, und durch den Inverter 52 invertierten Rechtecksignal Uh im punkt h der Schaltung die Abschalt-Spannungsspitze Ui an der Übertragerspule 19 ausgeblendet wird. Über die Gleichrichter-Glättungsstufe 45 wird abhängig von der Amplitude der Nadelimpulse die Referenzspannung auf den Minus-Eingang des Schmitt-Triggers nachgeführt, so daß am Ausgang des Schmitt-Triggers 44 unabhängig von der Amplitude der Nadelimpulse digitale Signale als serielle Bit-Folge im Dualcode über den Multiplexer 46 in den Mikroprozessor 48 gelangen. In einer durch den Mikroprozessor 48 realisierten Decodierschaltung wird die serielle Bit-Folge decodiert, in einem Bereich des Meßwertspeichers 49 abgelegt und zur weiteren Signalverarbeitung verwertet. Dabei bringt der Mikroprozessor 48 den ermittelten Meßwert beim Erreichen einer kritischen Grenze auf dem Display 50 zur Anzeige.

Da der Multiplexer 25 in der Sensorbeschaltung 20 nach jedem Steuerimpuls Ud der Zeitschaltung 30 zyklisch auf den nächsten Sensor bzw. auf eine Leerstellung fortgeschaltet wird, muß der Multiplexer 46 in der ortsfesten Auswerteschaltung 12 damit synchron arbeiten. Zu diesem Zweck ist der Multiplexer 46 mit seinem Steuereingang am Takteingang 51 der Auswerteschaltung 12 angeschlossen, auf dem die Signale Ua des Rechteckgenerators 15 über die Leitung 16 gelangen. Mit jeder ansteigenden Signalflanke wird der Multiplexer 46 als Demultiplexer arbeitend zyklisch auf den nächsten seiner Ausgänge bzw. auf eine Leerstellung umgeschaltet. Die Synchronisation des Multiplexers 46 der Auswerteschaltung 12 mit dem Multiplexer 25 der Sensorbeschaltung 20 erfolgt über die Leerstellung am Multiplexer 25 der Sensorbeschaltung 20. Sie wird jeweils zwischen zwei zyklischen Umschalt-Durchläufen des Multiplexers 25 in der Sensorbeschaltung 20 eingenommen. In der Leerstellung des Multiplexers 25 wird folglich über den Meßwertwandle 26 und der nachgeschalteten Koppelstufe 27 keine Impulsfolge in der Pausenzeit zeit t2 des Rechteckgenerators 15 übertragen. Die Leerstellung des Multiplexers 25 der Sensorbeschaltung 20 wird nunmehr in der Auswerteschaltung 12 mit dem UND-Gatter 47 erkannt, da in diesem Fall der eine mit dem Takteingang 51 verbundene Eingang des Gatters 47 durch die Ausgangssignale Ua des Rechteckgenerators 15 über den Inverter 52 und Verzögerungsstufe 63 auf 1 und der negierende andere Eingang des Gatters 47 durch die fehlenden Meßimpulse Ug am Ausgang der Gleichrichterglättungsstufe 45 auf 0 liegt. Der Ausgang des Gatters 47 ist mit dem Rücksetzeingang des Multiplexers 46 verbunden, so daß jeweils dann, wenn in der Pausenzeit t2 des Rechteckgenerators 15 keine Meßwertübertragung stattfindet der Multiplexer 46 in der Auswerteschaltung 12 über das UND-Gatter 47 zurückgesetzt bzw. mit dem Multiplexer 25 der Sensorbeschaltung 20 synchronisiert wird.

Die analogen Meßwerte der Sensoren 24 in der Sensorbeschaltung 20 werden durch die Digitalisierung am Meßwertwandler 26 in einer mehr oder weniger feinen Stufung aufgelöst, übertragen und ausgewertet. Dabei können durch Meßwerttoleranzen, durch mechanische Schwingungen am Fahrzeugrad oder durch andere Unzulänglichkeiten geringe Schwankungen der Meßwerte auftreten. Um derartige Schwankungen auszugleichen und um damit gleichzeitig die Meßgenauigkeit zu verbessern, ist vorgesehen, die in die Auswerteschaltung gelangenden Meßwerte als serielle Bit-Folge über eine bestimmte Periodenzahl des Rechteckgenerators 15 im Meßwertspeicher 49 (Figur 3) der Auswerteschaltung 12 aufzusummieren und daraus in Mikroprozessor 48 einen Mittelwert zu bilden, der gegebenenfalls über das Display 50 zur Anzeige kommt. Zu diesem Zweck ist zur Einstellung der Periodenzahl der Zähler 53 vorgesehen, der mit seinem Eingang über den Inverter 52 am Takteingang 51 mit den Rechtecksignalen Ua des Rechteckgenerators 15 verbunden ist und durch nicht dargestellte Schalter auf eine bestimmte Periodenzahl, im Beispielsfall auf die Zahl 15 eingestellt werden kann. Über den Ausgang des Zählers 52 wird der Meßwertspeicher 49 derart angesteuert, daß er für jeweils 15 Perioden des Rechteckgenerators 15 zum Einlesen von Meßwerten geöffnet ist, um diese anschließend zur Weiterverarbeitung an den Mikroprozessor 46 abzugeben. Da im Beispielsfall Reifendruck und Reifentemperatur voneinander unabhängig zyklisch übertragen und in entsprechend zugeordnete Bereiche des Speichers 49 eingelesen werden, ergibt sich bei der Periodenzahl 15 des Zählers 53, daß jeweils fünf Reifendruckmessungen und Temperaturmessung zur Mittelwertbildung herangezogen werden, während in den restlichen fünf Perioden des Rechteckgenerators 15 jeweils die Synchronisation der Multiplexer 25 und 46 erfolgt. Zweckmäßigerweise wird dabei die Abgabe der im Meßwertspeicher 49 gesammelten Meßdaten auf den Mikroprozessor 48 in einer Leerstellung der Multiplexer erfolgen.

Eine von elektromagnetischen Störungen abgekoppelte Auswertung der Takt- und Meßwertimpulse ist in bekannter Weise gegebenenfalls auch durch das Einfügen von Optokopplern in der Auswerteschaltung möglich. Für den Anschluß derartiger Optokoppler sind in Figur 3 zwei Anschlüsse 60, 61 gestrichelt dargestellt. Am Anschluß 61 kann das Steuersignal am Ausgang des Zählers 53 zur Ansteuerung externer Meßwertspeicher abgegriffen werden, während am Anschluß 60 die seriellen Meßwertimpulse in den Pausenzeiten t2 der Steuerimpulse Ua des Rechteckgenerators 15 abgegriffen werden können.

Die Erfindung ist nicht auf das dargestellte Ausführungsbeispiel beschränkt, da die zu übertragenden Meßwerte in verschiedenen Formen und Folgen von HF-Signalen in den Spannungspausen des Rechteckgenerators zu realisieren ist. Ebenso ist die Form der Signalauswertung nicht auf das Ausführungsbeispiel beschränkt. Erfindungswesentlich ist jedoch, daß die Sensorbeschaltung 20 ein Zeitglied 29 enthält, welches auf eine Spannungsspitze Ui in der umlaufenden Übertragerspule 19 anspricht, die durch das Ende eines Rechtecksignals Ua des Rechteckgenerators 15 erzeugt wird, und daß das Zeitglied 29 mit entsprechender Verzögerungszeit T1 eine ausgangsseitig an ihm angeschlossene Zeitschaltung 30 zur Meßwertübertragung freigibt, wobei die Verzögerungszeit T1 des Zeitgliedes 29 zusammen mit der Einschaltdauer T2 der Zeitschaltung 30 kleiner sein muß als die Pausenzeit t2 der Signale Ua am Rechteckgenerator 15. So ist es im Rahmen der Erfindung auch möglich, einen Meßwertwandler 26 in der Sensorschaltung 20 zu verwenden, der mit konstanter Frequenz während der Einschaltdauer T2 der Zeitschaltung 30 eine proportional zur abgegebenen Spannung der Sensoren 24 ansteigende Zahl von Spannungsimpulsen Ue abgibt, die in der Auswerteschaltung 12 jeweils für eine bestimmte Anzahl von Meßzyklen zur Ermittlung des Meßwertes aufsummiert werden. Außerdem kann als Meßwertwandler 26 ein proportional zur Spannung der Sensoren 24 arbeitender Frequenzwandler verwendet werden, so daß die frequenzabhängige Anzahl der Nadelimpulse Ug, die während der Einschaltdauer T2 der Zeitschaltung 30 in der Pausenzeit des Rechteckgenerators 15 übertragen werden ein Maß für den Reifendruck bzw. für die Reifentemperatur darstellt, z.B. ein Impuls pro 0,1 Bar oder 1°C. Auch hier läßt sich die Meßgenauigkeit dadurch erhöhen, daß im Meßwertspeicher 49 über mehrere Perioden des Rechteckgenerators 15 die übertragenden Meßimpulse aufsummiert werden.

In Figur 3 ist die Auswerteschaltung 12 lediglich für ein Fahrzeugrad dargestellt und erläutert. Da Luftdruck und Temperatur der übrigen Fahrzeugräder in gleicher Weise ermittelt werden, ist der Multiplexer 46 mit einer entsprechenden Anzahl von gestrichelt angedeuteten Eingängen für weitere Schmitt-Trigger 44 versehen, zwischen denen der Multiplexer 46 über einen mit dem Ausgang des Zählers 53 verbundenen Steuereingang jeweils nach 15 Perioden des Rechteckgenerators 15 umgeschaltet wird. Mit dem Mikroprozessor 48 kann außerdem eine weitere Verarbeitung der ermittelten Meßwerte in der Art durchgeführt werden, daß über einen weiteren Ausgang 62 eine Einrichtung zur Regelung des Luftdrucks in den einzelnen Fahrzeugreifen angesteuert wird. Da in solchen Fällen die verschiedenen Meßwerte aller zu überwachenden Fahrzeugräder in möglichst rascher Folge zur Verfügung stehen müssen, bietet hier die Übertragung der Meßwerte als serielle Bit-Folge im Dualcode die Möglichkeit, jeden Meßwert mit hoher Genauigkeit durch entsprechend hohe digitale Auflösung des analogen Meßwertes während einer Periode des Rechteckgenerators 15 zuverlässig zu übertragen. Außerdem können hierbei bestimmte Bits, beispielsweise die ersten oder die letzten zwei Bits einer Signalfolge zur Kennung des übertragenen Meßwertes verwendet werden, wodurch eine Meßwertumschaltung am Multiplexer 46 der Auswerteschaltung 12 entfallen kann. Da der Mikroprozessor 48 durch die Kennung den übertragenen Meßwert identifizieren und entsprechend verarbeiten kann, wird der Multiplexer 46 hierbei lediglich noch zur zyklischen Umschaltung der Auswerteschaltung auf die verschiedenen Fahrzeugräder benötigt. Ebenso ist es im Rahmen der Erfindung möglich, den Multiplexer 46 bzw. einen Demultiplexer vor dem HF-Filter 42 anzuordnen um dann für die Übertragung des Reifendrucks bzw. der Reifentemperatur aller Fahrzeugräder jeweils nur einen Schmitt-Trigger 44 zu verwenden.

## Ansprüche

1. Schaltungsanordnung zur Übertragung von veränderlichen Meßwerten wie Druck und Temperatur an Fahrzeugrädern mit einer am Fahrzeug in Radnähe ortsfest angeordneten Übertragerspule, die einerseits zur Energieversorgung einer mit dem Fahrzeugrad umlaufenden Sensorbeschaltung an einem Rechteckgenerator und andererseits zur Übertragung von Meßwerten in den Spannungspausen des Rechteckgenerators an eine Auswerteschaltung angeschlossen ist, und mit einer umlaufenden, am Fahrzeugrad befestigten, mit der ortsfesten Übertragerspule zusammenwirkenden weiteren Übertragerspule, die zur Energieversorgung einerseits und zur Meßwertübertragung andererseits mit der Sensorbeschaltung am Fahrzeugrad verbunden ist, welche einen Meßwertwandler aufweist, der die von mindestens einem Sensor erzeugten Meßwerte in Form von HF-Signalen in den Spannungspausen des Rechteckgenerators auf die Übertragerspule gibt und deren Frequenz ein Vielfaches der Frequenz des Rechteckgenerators ist, dadurch gekennzeichnet, daß die Sensorbeschaltung (20) ferner ein Zeitglied (29) enthält, welches auf einen durch das Ende eines Spannungsimpulses (Ua) am Rechteckgenerator (15) erzeugten Spannungsspitze (Ui) in der umlaufenden Übertragerspule (19) anspricht und das mit entsprechender Verzögerungszeit (T1) eine ausgangsseitig an ihm angeschlossene Zeitschaltung (30) zur Meßwertübertragung freigibt, wobei die Verzögerungszeit (T1) des Zeitgliedes (29) zusammen mit der Einschaltdauer (T2) der Zeitschaltung (30) kleiner als die Pausenzeit (t2) der Rechteckspannung am Rechteckgenerator (15) ist.

2. Schalturigsanordnung nach Anspruch 1, dadurch gekennzeichnet, daß die von dem Zeitglied (29) freigegebene Zeitschaltung (30) eine monostabile Kippstufe ist, über deren Ausgang der Meßwertwandler (26) und eine diesem nachgeschaltete Treiberstufe (27) für die Weiterleitung der HF-Signale auf die umlaufende Übertragerspule (19) einzuschalten ist.

3. Schaltungsanordrdung nach Anspruch 2, dadurch gekennzeichnet, daß die Treiberstufe (27) aus zwei in Reihe liegende, an die Versorgungsspannung der Sensorschaltung (20) angeschlossene Transistorschalter (31, 32) besteht, die vom Ausgang des Meßwertwandlers (26) im Gegentakt gesteuert werden und deren Verbindung über einen Kondensator (28) mit der umlaufenden Übertragerspule (19) gekoppelt ist.

4. Schaltungsanordnung nach Anspruch 2 oder 3, dadurch gekennzeichnet, daß der Meßwertwandler (26) ein Analog-Digital-Kodierer (ADC) ist, der die Meßwerte mindestens eines Sensors (24) als serielle Bit-Folge im Dualcode auf die Treiberstufe (27) gibt und dem ein entsprechender Decodierer (48) in der Auswerteschaltung (12) zugeordnet ist.

5. Schaltungsanordnung nach einem der vorherigen Ansprüche, dadurch gekennzeichnet, daß die als HF-Signale über ein Siebglied (42) von der ortsfesten Übertragerspule (13) in die Auswerteschaltung (12) gelangenden Meßwerte über eine bestimmte Periodenzahl des Rechteckgenerators (15) in einem Meßwertspeicher (49) aufsummiert werden und ein daraus abgeleiteter Mittelwert zur Anzeige kommt.

6. Schaltungsanordnung nach Anspruch 5, dadurch gekennzeichnet, daß die Auswerteschaltung (12) für jedes Fahrzeugrad einen Schmitt-Trigger (44) enthält, dessen Plus-Eingang über einen Widerstand (43) und dessen Minus-Eingang über eine Gleichrichter-Glättungsstufe (45) mit dem Ausgang des Siebgliedes (42) verbunden ist.

7. Schaltungsanordnung nach Anspruch 5, dadurch gekennzeichnet, daß der Meßwertspeicher (49) von einem Zähler (53) angesteuert wird, der mit seinem Eingang mit dem Ausgang des Rechteckgenerators (15) in Verbindung steht.

8. Schaltungsanordnung nach Anspruch 1 oder 7, dadurch gekennzeichnet, daß der Rechteckgenerator (15) zur konstanten Energieversorgung der Sensorbeschaltung (20) eine astabile Kippstufe (54) enthält, deren Zeitglied (55, 57) an der ungeregelten Versorgungsspannung der ortsfesten Übertragerspule (13) liegt, so daß sich die Taktfrequenz der Kippstufe (54) in Abhängigkeit von der Spannungsänderung der Versorgungsspannung des Zeitgliedes ändert.

9. Schaltungsanordnung nach Anspruch 1, dadurch gekennzeichnet, daß zur zyklischen Übertragung mehrerer Meßwerte an einem Fahrzeugreifen ein in der Sensorbeschaltung (20) zwischen mehreren Sensoren (24) und dem Meßwertwandler (26) angeordneter Multiplexer (25) mit seinem Takteingang am Ausgang der Zeitschaltung (30) liegt.

10. Schaltungsanordnung nach Anspruch 9, dadurch gekennzeichnet, daß der Multiplexer (25) in der Sensorbeschaltung (20) zwischen zwei zyklischen Umschalt-Durchläufen eine Leerstellung einnimmt, in der keine Meßwertübertragung stattfindet und daß ein in der Auswerteschaltung (12) angeordneter Multiplexer (46) zur Synchronisation durch diese Leerstellung zurückzusetzen ist.

## Claims

1. Circuit arrangement for transmitting variable values such as pressure and temperature measured at vehicle wheels comprising a transformer coil arranged stationary close to the wheel on the vehicle, which is connected, on the one hand, to a square wave generator for supplying energy to a sensor circuit revolving with the vehicle wheel and, on the other hand, is connected to an evaluating circuit for transmitting measurement values in the voltage pauses of the square wave generator, and comprising a revolving further transformer coil which is attached to the vehicle wheel and acts in conjunction with the stationary transformer coil, which further coil is connected, on the one hand for supplying energy and, on the other hand for transmitting measurement values, to the sensor circuit on the vehicle wheel, which exhibits a measurement value converter which supplies the measurement values generated by at least one sensor in the form of HF signals to the transformer coil in the voltage pauses of the square wave generator and the frequency of which is a multiple of the frequency of the square wave generator, characterised in that the sensor circuit (20) also contains a timing section (29) which responds to a voltage peak (Ui) in the revolving transformer coil (19), generated by the end of a voltage pulse (Ua) at the square wave generator (15), and which enables, with corresponding delay time (T1), a timing circuit (30) connected to it at the output side for measurement value transmission, the delay time (T1) of the timing section (29) together with the on time (T2) of the timing circuit (30) being shorter than the pause time (t2) of the square wave voltage at the square wave generator (15).

2. Circuit arrangement according to Claim 1, characterised in that the timing circuit (30) enabled by the timing section (29) is a monostable flip flop, via the output of which the measurement value converter (26) and a driver stage (27), following it, is to be switched on for forwarding the HF signals to the revolving transformer coil (19).

3. Circuit arrangement according to Claim 2, characterised in that the driver stage (27) consists of two series-connected transistor switches (31, 32), connected to the supply voltage of the sensor circuit (20), which are controlled in push-pull by the output of the measurement value converter (26) and the connection of which is coupled to the revolving transformer coil (19) via a capacitor (28).

4. Circuit arrangement according to Claim 2 or 3, characterised in that the measurement value converter (26) is an analog/digital coder (ADC) which supplies the measurement values of at least one sensor (24) as serial bit sequence in binary code to the driver stage (27) and which is associated with a corresponding decoder (48) in the evaluating circuit (12).

5. Circuit arrangement according to one of the preceding claims, characterised in that the measurement values, which pass as HF signals via a filter section (42) from the stationary transformer coil (13) into the evaluating circuit (12), are summed together over a particular number of periods of the square wave generator (15) in a measurement value store (49) and that a mean value derived from this is displayed.

6. Circuit arrangement according to Claim 5, characterised in that the evaluating circuit (12) contains for each vehicle wheel one Schmitt trigger (44), the positive input of which is connected via a resistor (43) and the negative input of which is connected via a rectifier smoothing stage (45) to the output of the filter section (42).

7. Circuit arrangement according to Claim 5, characterised in that the measurement value store (49) is driven by a counter (53) the input of which is connected to the output of the square wave generator (15).

8. Circuit arrangement according to Claim 1 or 7, characterised in that the square wave generator (15) contains, for supplying constant energy to the sensor circuit (20), an astable flip flop (54) the timing section (55, 57) of which is connected to the unregulated supply voltage of the stationary transformer coil (13) so that the clock frequency of the flip flop (54) changes in dependence on the voltage change of the supply voltage of the timing section.

9. Circuit arrangement according to Claim 1, characterised in that a multiplexer (25) arranged in the sensor circuit (20) between several sensors (24) and the measurement value converter (26) is connected with its clock input to the output of the timing circuit (30) for the cyclic transmission of several values measured at a vehicle tyre.

10. Circuit arrangement according to Claim 9, characterised in that the multiplexer (25) in the sensor circuit (20) assumes a blank position between two cyclic switch-over runs in which no measurement value transmission occurs and that a multiplexer (46) arranged in the evaluating circuit (12) must be reset by this blank position for the purpose of synchronisation.

**Revendications**

1. Agencement de circuit pour transmettre des valeurs variables, telles que la pression et la température mesurées sur des roues de véhicules, avec une bobine de transmission disposée à poste fixe sur le véhicule au voisinage de la roue, et qui est raccordée, d'une part, à un générateur d'impulsions rectangulaires pour alimenter en énergie un circuit de détection tournant avec la roue du véhicule, et, d'autre part, à un circuit d'exploitation pour la transmission des valeurs de mesure pendant les pauses de tension du générateur d'impulsions rectangulaires, et avec une autre bobine de transmission tournante, fixée sur la roue du véhicule, coopérant avec la bobine de transmission à poste fixe et qui est reliée au circuit de détection sur la roue du véhicule, pour permettre, d'une part, l'alimentation en énergie et, d'autre part, la transmission des valeurs de mesure, cet agencement comportant un convertisseur de valeur de mesure qui délivre à la bobine de transmission, sous forme de signaux HF dans les pauses de tension du générateur d'impulsions rectangulaires, les valeurs de mesure produites par au moins un détecteur, et dont la fréquence est un multiple de la fréquence du générateur d'impulsions rectangulaires, agencement de circuit caractérisé en ce que le circuit de détection (20) comporte en outre, un organe de temporisation (29) qui réagit à une pointe de tension (Ui) produite dans la bobine de transmission tournante (19) par la fin d'une impulsion de tension (Ua) sur le générateur d'impulsions rectangulaires (15), et qui, avec un temps de retard approprié (T1) libère pour la transmission de la valeur de mesure un circuit de temporisation (30) qui lui est raccordé côté sortie, le temps de retard (T1) de l'organe de temporisation (29) conjointement avec la durée de mise en circuit (T2) du circuit de temporisation (30) étant plus petit que la période de pause (t2) de la tension rectangulaire sur le générateur d'impulsions rectangulaires (15).

2. Agencement de circuit selon la revendication 1, caractérisé en ce que le circuit de temporisation (30) libéré par l'organe de temporisation (29) est un étage basculant monostable, par l'intermédiaire de la sortie duquel le convertisseur de valeur de mesure (26) et un étage d'attaque (27) branché à la suite de celui-ci, sont susceptibles d'être mis en circuit pour la transmission des signaux HF à la bobine de transmission tournante (19).

3. Agencement de circuit selon la revendication 2, caractérisé en ce que l'étage d'attaque (27) est constitué par deux commutateurs à transistors (31, 32) placés en série et raccordés à la tension d'alimentation du circuit de détection (20), qui sont commandés en push-pull à partir de la sortie du convertisseur de valeur de mesure (26) et dont la jonction est couplée par l'intermédiaire d'un condensateur (28) à la bobine de transmission tournante (19).

4. Agencement de circuit selon la revendication 2 ou la revendication 3, caractérisé en ce que le convertisseur de valeur de mesure (26) est un codeur analogique-numérique (ADC) qui délivre les valeurs de mesure d'au moins un détecteur (24) sous la forme d'une succession sérielle de chiffres binaires en code dual à l'étage d'attaque (27) et auquel est associé un décodeur correspondant (48) dans le circuit d'exploitation (12).

5. Agencement de circuit selon une des précédentes revendications, caractérisé en ce que les valeurs de mesure arrivant de la bobine de transmission fixe (13) dans le circuit d'exploitation (12) sous la forme de signaux HF par l'intermédiaire d'un organe de filtrage (42), sont totalisées dans une mémoire de valeur de mesure (49) sur un nombre de périodes déterminées du générateur d'impulsions rectangulaires (15), et une valeur moyenne dérivée de cette totalisation est affichée.

6. Agencement de circuit selon la revendication 5, caractérisé en ce que le circuit d'exploitation (12) comprend pour chaque roue du véhicule un déclencheur de Schmitt (44) dont l'entrée positive est reliée par l'intermédiaire d'une résistance (43) et dont l'entrée négative est reliée par l'intermédiaire d'un étage de lissage et de redressement (45) à la sortie de l'organe de filtrage (42).

7. Agencement de circuit selon la revendication 5, caractérisé en ce que la mémoire de valeur de mesure (49) est commandée par un compteur (53) dont l'entrée est reliée à la sortie du générateur d'impulsions rectangulaires (15).

8. Agencement de circuit selon la revendication 1 ou la revendication 7, caractérisé en ce que le générateur d'impulsions rectangulaires (15) comprend, pour permettre une alimentation constante en énergie du circuit de détection (20), un étage basculant astable (54) dont l'organe de temporisation (55, 57) est à la tension d'alimentation non réglée de la bobine de transmission fixe (13) de sorte que la fréquence de synchronisation de l'étage basculant (54) se modifie en fonction de la modification de la tension d'alimentation de l'organe de temporisation.

9. Agencement de circuit selon la revendication 1, caractérisé en ce que pour la transmission cyclique de plusieurs valeurs de mesure sur une pneumatique du véhicule, l'entrée de synchronisation d'un multiplexeur (25), disposé dans le circuit de détection (20) entre plusieurs détecteurs (24) et de convertisseurs de mesure (26) est reliée à la sortie du circuit de temporisation (30).

10. Agencement de circuit selon la revendication 9, caractérisé en ce que le multiplexeur (25) dans le circuit de détection (20) prend entre deux parcours de commutation cycliques, une position vide dans laquelle aucune transmission de valeur de mesure n'a lieu, et en ce qu'un multiplexeur (46) disposé dans le circuit d'exploitation (12) est remis à l'état initial par cette position vide pour permettre la synchronisation.

FIG.1

FIG.2

FIG.3

EP 0 290 438 B1

# FIG.4

# FIG.5